(19) **Europäisches Patentamt / European Patent Office / Office européen des brevets**

(11) **EP 4 027 204 B1**

(12) # EUROPEAN PATENT SPECIFICATION

(45) Date of publication and mention
of the grant of the patent:
**06.11.2024 Bulletin 2024/45**

(21) Application number: **22150482.2**

(22) Date of filing: **06.01.2022**

(51) International Patent Classification (IPC):
*G05B 9/02* *(2006.01)*    *G05B 19/418* *(2006.01)*

(52) Cooperative Patent Classification (CPC):
**G05B 19/4184; G05B 9/02;** G05B 2219/31461

(54) **SYSTEM AND METHOD FOR MODELLING AND ASSESSING RISKS**

SYSTEM UND VERFAHREN ZUR MODELLIERUNG UND BEWERTUNG VON RISIKEN

SYSTÈME ET PROCÉDÉ DE MODÉLISATION ET D'ÉVALUATION DES RISQUES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.01.2021 SG 10202100169Q**

(43) Date of publication of application:
**13.07.2022 Bulletin 2022/28**

(73) Proprietor: **TUV SUD Hong Kong Limited
Shatin, Hong Kong (HK)**

(72) Inventors:
- **Puto, Robert
  20852 Villasanta
  (Monza Brianza) (IT)**
- **Saerbeck, Martin
  Singapore (SG)**
- **Pfeifer, Michael
  85221 Dachau (DE)**
- **Haifeng, Zhu
  Guangzhou City 510277 (CN)**
- **Seidel, Enrico
  85737 Ismaning (DE)**

(74) Representative: **HGF
HGF Limited
1 City Walk
Leeds LS11 9DX (GB)**

(56) References cited:
**US-A1- 2019 050 942    US-A1- 2019 164 095
US-A1- 2020 111 038**

- **GRAN ET AL: "Addressing dependability by
applying an approach for model-based risk
assessment", RELIABILITY ENGINEERING AND
SYSTEM SAFETY, ELSEVIER APPLIED
SCIENCE, GB, vol. 92, no. 11, 10 July 2007
(2007-07-10), pages 1492 - 1502, XP022146374,
ISSN: 0951-8320, DOI:
10.1016/J.RESS.2006.10.002**
- **ASIA INFORMATION RETRIEVAL SYMPOSIUM,
AIRS 2004(LNCS3411, SPRINGER, 2005)(ISBN
3540250654)(349S).PDF#PAGE=313: "Lecture
Notes in Computer Science 3411", 20 October
2004 (2004-10-20), XP055154701, Retrieved from
the Internet
<URL:http://nozdr.ru/data/media/biblioteka/kolx
o3/Cs_Computer_science/CsLn_Lecture>
[retrieved on 20141124]**

## Description

### TECHNICAL FIELD

The present disclosure relates to a system and method for modelling and assessing risks.

### BACKGROUND

The following discussion of the background is intended to facilitate an understanding of the present disclosure only. It should be appreciated that the discussion is not an acknowledgement or admission that any of the material referred to was published, known or is part of the common general knowledge of the person skilled in the art in any jurisdiction as of the priority date of the invention.

Risk modelling and assessment are necessary activities throughout the lifecycle of a component, device or system. One method includes manually documenting potential hazards and possible mitigation of such hazards. Although tool support such as spreadsheets may be available to support the documentation process, tool support is typically utilized for managing the documentation and not available for performing deep semantic analysis or performing the decision processes automatically. In addition, manual documentation of risk identification can be labour intensive - this can result in increased costs, reduced efficiency or human errors.

In addition to the manual approach as mentioned, various approaches to model and evaluate risks have been contemplated, for example model-based engineering methods. In general, such model-based engineering methods aim to provide notations and tools to model functional and safety relevant properties in one overarching system design, integrating design and risk assessment. This link between "designing a system" and "assessing a system" is especially problematic for independent review. Furthermore, the integration unnecessarily limits risk assessment and evaluation to the elements included in the model. Consequently, any protective measure that exists in the environment, but is not part of the system design, will be missed. In addition, the model-based engineering method also falls short to analyse system-of-systems of dynamically or spontaneously interacting systems. Furthermore, the engineering methods usually requires all vendors to design their components with the same methodology, which may be an unrealistic assumption.

Another approach, summarized as "run-time methods", propose various ways to estimate risk of a system under assessment at run-time and change system behaviour accordingly. It is to be appreciated that such methods do not evaluate a protective measure but instead implement the same.

Another approach, summarized as "formal methods", rely on formal modelling of the underlying system. However, such models are generally difficult to use because risk assessors may not be versed in formal modelling. In addition, known formal models may be limited in their application and involve the use of intensive computational resources due to the computational complexity associated with formal modelling. Existing formal approaches may not be able to handle dynamic changes and interacting elements within the system under assessment desirably.

U.S. Patent Application 2019/164095A1 entitled "Natural language processing of feeds into functional software input" published 30 May 2019 disclosed a method, in a data processing system comprising a processor and a memory, for processing natural language feeds to software. The disclosed method comprised receiving, by the data processing system, a natural language feed including data that is representative of parameters and quantitative data from government or regulatory body data sources, parsing, by the data processing system, the natural language feed with natural language processing for features that correspond to a production system, converting, by the data processing system, the parsed natural language feed into software functions, and calibrating, by the data processing system, the production system by updating a data library using the software functions and integrating information from the data library with the production system.

U.S. Patent Application 2019/050942A1 entitled "Systems and methods for dynamic real-time analysis from multi-modal data fusion for contextual risk identification" published 14 February 2019 disclosed a system and method to automatically identify property-related risks through the use of computer vision, sensors, and/or building information models (BIMs). The publication disclosed the ability to automatically identify a variety of hazards helps mitigate the associated risks, and thus reduce the number of accidents or fatalities that would otherwise occur. In some embodiments of the publication, a "risk map" was be generated by mapping the identified risks for a given property.

U.S. Patent Application 2020111038A1 entitled "Identifying and evaluating risks across risk alert sources" published 09 April 2020 disclosed methods, systems, and computer program products for identifying and evaluating risk alerts are provided. Aspects included receiving risk alert data comprising risk alerts from data sources, obtaining, by the processor, client geographical data comprising one or more locations of interest, wherein the one or more locations of interest comprise infrastructure resource for the client, determining one or more trusted data sources that are most relevant to define an impact of one or more risk events from the risk alert data affecting one or more locations of interest for the client based on the risk alert data and the client geographical data, determining impactful risk events that affect locations of interest for the client based on trusted risk alert data from the trusted data sources and the client geographical data, and displaying the trusted data sources, the one or more impactful risk events, and the one or more locations.

"Addressing dependability by applying an approach for model-based risk assessment", authored by Bjorn Axel Gran et al., published in Reliability Engineering and System Safety, volume 92, number 11, published 10 July 2007, pages 1492-1502 disclosed an approach for model-based risk assessment (MBRA) that can be applied for addressing different dependability factors in a critical application. The publication disclosed a tool-supported methodology for the application of MBRA in security-critical systems and was applied as a part of a trust case development.

In summary, existing systems and methods have significant shortcomings for modelling and assessing risks. Depending on the method used, they are unable to achieve complete independence from the system under assessment, are unable to achieve complete modelling of risks, and are typically domain specific.

There exists a need for an improved system and method to alleviate one or more of the aforementioned problems.

## SUMMARY

This disclosure provides for a system capable of automatically assessing the safety and/or security compliance of inter-acting industrial assets in an adaptive or dynamic manner.

It addresses safety and/or security challenge posed by Industry 4.0 paradigm, i.e. increased inter-connectivity, flexibility and adaptability to change, with the aim to maximize asset efficiency and value generation.

The system features a method to model the safety and security risks of an industrial asset as defined in existing standards. In a physical safety domain, a risk may be associated with harm in the form of physical injury or other consequences to the health of living beings, such as human beings. The method can additionally model and assess safety risks associated with physical damage to property and/or environment. Overall, it enables assessment of application specific safety and security risks arising from the interaction of any pair of assets. The disclosure is suited for improving the speed and flexibility of risk assessment in a manner so as to reduce human error. The system and method may be deployed in various operational use cases.

The system can be integrated with traditional workflow of safety and/or security assessment. It can also form part of the development activities for the design and manufacturing of components, products, and sub-systems in the context of industrial internet of things (IIoT).

The system may also be used for future standardization efforts. It is appreciable that the system and method provides a formalism that is easy to understand for subject matter experts but is still formally correct. It overcomes the challenge to be accessible by people and by machines.

The system can be deployed alongside an already validated system application in terms of safety and/or security to dynamically re-evaluate conformance when certain properties or parameters within the system under assessment (SUA) change.

The system models one or more risks (hazards/threats) in terms of mapping natural language to a machine-interpretable semantic that are based on functional and operational adjustments of the SUA. Such a mapping formalizes risk assessment (which may include risk analysis, risk estimation and risk evaluation) in a machine-readable language to allow adaptive risk assessment, risk reduction and as a result ideally automatic safety certification.

The system semantic can be formally defined as a risk model associated with the SUA. Each layer in the abstraction hierarchy of the risk model can be reduced to lower-level constructs, providing precise semantic meaning. At the lowest level, the hazard modelling as well as risk assessment and reduction according to the present disclosure is based on the mathematical rigor of set theory, type theory, and structures.

Other aspects and features of the disclosure are described in the following description of specific embodiments in conjunction with the accompanying figures. It will be appreciated and understood by those of ordinary skill in the art that the embodiments are non-limiting examples.

## BRIEF DESCRIPTION OF DRAWINGS

In the figures, which illustrate, by way of example only, embodiments of the present invention,

Fig. 1 shows a conceptual overview of a relationship between the risk modelling and assessment system of the present disclosure and a system under assessment.

Fig. 2 is a system diagram of the risk modelling and assessment system according to an embodiment.

Fig. 3a, 3b, 3c and 3d illustrate a possible structure of an electronic model specification 120 for use with the risk modelling and assessment system. Fig. 3a illustrates a syntax of the electronic model specification 120 in XML format, Fig. 3b tabulates top-level elements of the modelling language, Fig. 3c tabulates the base language elements of the modelling language, and Fig. 3d tabulates the base types of the type system.

Fig. 4 shows the components of an extensible application programming interface (API) that can be used for the implementation of risk modelling and risk assessment according to some embodiments.

Fig. 5 shows an embodiment of the modelling language components used for the creation of one or more electronic model specifications.

Fig. 6 illustrates an embodiment of a support tool, in the form of a graphical interface, to facilitate the creation of one or more electronic model specifications.

Fig. 7 illustrates a hardware embodiment of the risk modelling and risk assessment system in the form of an integrated circuit chip (IC).

Fig. 8 illustrates an embodiment wherein the risk modelling and risk assessment system is distributed and deployed as a service over a network.

Fig. 9 is a flow chart depicting an embodiment of a method for modelling risks associated with a system under assessment.

Fig. 10 is a flow chart depicting an embodiment of a method for risk assessment associated with a system under assessment.

## DESCRIPTION OF EMBODIMENTS

As used herein, the term "comprise" or variations such as "comprises" or "comprising" will be understood to imply the inclusion of a stated integer or group of integers but not the exclusion of any other integer or group of integers.

As used herein, the term "include" or variations such as "includes" or "including" will be understood to imply the inclusion of a stated integer or group of integers but not the exclusion of any other integer or group of integers.

As used herein, the term "may" or "can" will be understood to imply the inclusion of a stated integer or group of integers but not the exclusion of any other integer or group of integers.

As used herein, the term "system under assessment" (SUA) refers to any system that is suitable to be interfaced with the risk modelling and risk assessment system of the present disclosure. Non-limiting examples of SUA includes a production system, a manufacturing system, a logistic system, a chemical plant/reactor system, a waste incineration system, an explosion protection zone, a construction site, a nuclear plant, an oil refinery, a gas refinery, a cyber security system, an automation and control system, and one or more combinations of the aforementioned systems. An SUA can be as small as a single machine, vehicle and/or a product. The SUA may refer to the entire system that is being evaluated, regardless of its hierarchical or heterarchical composition. The SUA can also include two or more systems that interact with one another during operation.

As used herein, the term "element of an SUA" can refer to a constituent of the SUA. Non-limiting examples include a physical facility such as a room, a building, a shelf; a vehicle such as an automated guided vehicle, a forklift, a transport vehicle; one or more machines; and/or a part of or a section of the physical facility, vehicle, machines, etc. The element of an SUA also includes logical constituents such as one or more of the following: operating system, network driver, software application, encryption service, safety function, etc.

As used herein, the term 'risk' includes a safety breach, hazard and/or a security breach, hazard. As used herein, the term 'risk' also include instances of safety and/or security gaps against tolerable risk levels as defined in current technical standards. Non-limiting examples of such risks includes entrapment risk (i.e. human operator trapped by one or more machines), explosion risk, fire risk, theft, unauthorized entry into a premise, unauthorized obtainment of confidential information etc.

As used herein, the term 'risk related property' refers to an attribute that is associated with one or more types of risk in the context of an SUA. For example, a risk related property can be a spark within a room of flammable materials that can lead to an explosion risk, a vehicle in a path of an object/person that can lead to a collision risk, etc. Risk related property can also include an attribute for mitigating the risk (e.g. safety functions and security countermeasures), as well as general context information (e.g. gravitational force of Earth).

As used herein, the term 'natural language' includes one or more languages that has been developed naturally in use by human beings and can include languages such as English, Chinese, Japanese, German. The term 'natural language' can also include dialects and colloquialism.

As used herein, the term 'system semantic' refers to a semantic utilized within the context of an SUA. The system semantic comprises syntax that can be understood by a human person and can also be interpreted by suitable computer compilers/processors and its meaning for the system.

As used herein, the term 'condition' represents a proposition expressed in natural or pseudo-natural language and mappable to a system semantic. The proposition comprises one or more expressions that can give rise to a risk. If the condition is evaluated to a 'true', an unacceptable/ unmitigated risk associated with the condition exists. If the condition is evaluated to a 'false', the risk associated with the condition is deemed "tolerable", hence additional safety and/or security measures are not necessary.

As used herein, the terms 'risk assessment' and 'risk evaluation' are understood to be intentionally separated and independent from the design of the SUA. In addition, the terms 'risk assessment' and 'risk evaluation' are separate and independent from the recommendations to mitigate any identified risks. Risk assessment and risk evaluation results are primarily used to verify and/or validate a design and list non-conformances. In particular, the term risk assessment includes risk analysis, evaluation and/or risk reduction.

As used herein, the term 'network' can be any means of providing communication between one or more devices and/or content stored elsewhere. As used herein, network can be a personal area network, local area network, a storage area network, a system area network, a wide area network, a virtual private network, and an enterprise private network. The network can include one or more gateways or no gateways. The network communication can be conducted via published standard protocols or proprietary protocols.

As used herein, communication of data through any network can be: (i) encoded or unencoded; (ii) encrypted or unencrypted; (iii) delivered via a wired network, a wireless network, or a combination of wired and wireless networks. Wireless communication can be accomplished in any practical manner including a Wi-Fi 802.11 network, a Bluetooth™ network, or mobile phone network (such as 3G, 4G, LTE, and 5G). The terms "connect", "connected", and "connecting" as used herein refer to a communication link between at least two devices and can be accomplished as discussed in this paragraph.

As used herein, the term "associate", "associated", and "associating" indicate a defined relationship (or cross-reference) between at least two items. Such defined relationship may be expressed in one or more mathematical equations and/or formulas.

As used herein, the term "computing device" may be a single stand-alone computer such as a desktop computer or a laptop computer, a thin client, a tablet computer, an embedded computer or a mobile phone. The computing device may run a local operating system and store computer files on a local storage drive. The computing device may access files and application through a gateway to one or more content repositories, the content repository can host files and/or run virtual applications and generate a virtual desktop for the computing device.

As used herein, the term "server" may include a single stand-alone computer, a single dedicated server, multiple dedicated servers, and/or a virtual server running on a larger network of servers and/or cloud-based service. A server may also include virtual machines, and can include one or more computing services hosted on cloud. Cloud could be either private or public commercial cloud.

As used herein, the term "run time" is used in the context of a computer processing term in relation to the implementation and execution of the present system. The run time may or may not be required to meet real time requirements.

As used herein, the term "parameter" includes variables, constants, any measurable (quantitative or qualitative) quantities, and the derivatives of any of the aforementioned.

As used herein, the term "physical property" refers to a property that is measurable, whose value describes a state of a SUA. Non-limiting examples of physical property includes temperature, colour, pressure, distance, response time, memory consumption of a computer, etc.

As used herein, the term "functional property" refers to the performance, accuracy and consistency of an output of a system in response to an input. For example, a car braking system may be required to brake within a certain distance (output) when an input braking force is applied.

An embodiment of the invention includes a system (100) for modelling and assessment of risks for a system under assessment SUA (1900). The system (100) comprises a plurality of electronic model specification fragments in a modelling language residing at one or more first network nodes. The modelling language includes a plurality of rules that define each model specification fragment in a desired language realization. Each electronic model specification fragment comprises: a definition section including default constructs and user defined constructs; an application section (140); and a condition section (146). The application section (140) includes at least one element of the SUA (1900). The at least one element includes at least one of a safety section (142) and a security section (144). The at least one of a safety section (142) and security section (144) comprises a plurality of risk related properties, wherein the plurality of risk related properties are mapped from a natural language to a system semantic. The system semantic includes a physical or functional property of the SUA (1900). The condition section (146) specifies at least one condition for at least one of a safety risk and a security risk to materialize. The at least one condition comprises at least one of the plurality of risk related properties. The system (100) further comprises a computer-assisted tool to manage the plurality of electronic model specification fragments to create an electronic model specification (120) of the SUA (1900). The system (100) further comprises an evaluation engine (160) residing at a second network node. The evaluation engine (160) is configured to evaluate, for the electronic model specification (120) of the SUA (1900), the at least one condition to determine if an unmitigated risk exists. The evaluation engine (160) is configured to receive a set of reference parameters from the SUA (1900) to define a search space for the at least one condition. The defined search space represents a set of solutions that comprises one or more unmitigated risks. The system (100) is arranged in communication with the SUA (1900) to receive the reference parameters from the SUA (1900) and the SUA (1900) is an industrial asset including a production system or a manufacturing system.

According to an aspect of the disclosure there is a system for modelling and assessing risks comprising: at least one electronic model specification associated with an SUA, the electronic model specification comprises an application section associated with at least one element of the SUA; the application section includes at least one of a safety section and a security section associated with the at least one element; wherein at least one of a safety section and security section comprises a plurality of risk related properties; the plurality of risk related properties mappable from a natural language to a system semantic, the system semantic associated with a physical or functional property of the SUA; and a condition section specifying at least one condition associated with at least one of a safety breach and a security breach to materialize; wherein the at least one condition comprises at least one of the plurality of risk related property; an evaluation engine configured to evaluate the at least one condition associated with the at least one of a safety breach and a security breach to determine if a risk exists.

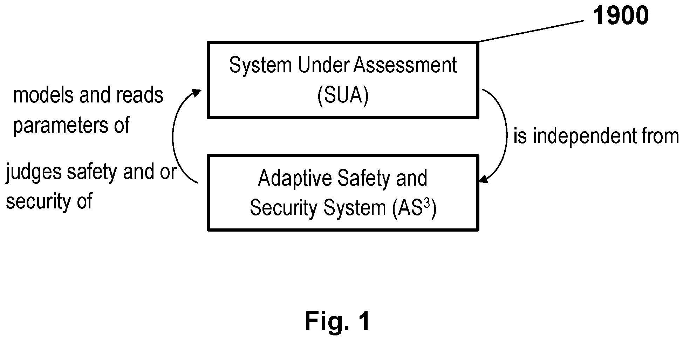

Fig. 1 shows a conceptual overview of a relation between the risk modelling and assessment system 100 of the present disclosure and a SUA 1900. The system 100 may be arranged in communication with the SUA 1900 to obtain information from the same, so as to at least partially derive an input. The communication between the system 100 and SUA 1900 can be wired or wireless. Alternatively the system 100 may not be in communication with the SUA 1900 and inputs are provided manually to the system 100. The system 100 is independent from the SUA 1900 in the sense that the SUA is not influenced in its workings by the presence, usage or interaction with the system 100. The system 100 is configured to model and assess the SUA 1900. If at least one risk exists, the system 100 models at least one risk in the form of a list of conditions, such as a conjunctive list of conditions that causes the risk to materialize, for a user's action. If a risk can arise due to multiple possibilities or multiple risks are present, the conjunctive list of conditions may be combined using disjunction. It is appreciable that the list of conditions includes a plurality of risk related properties.

As shown in Fig. 1, the system 100 models and obtains parameters of the SUA 1900. Where any changes are made to the SUA, the system 100 may obtain changed parameters during run-time. The system 100 may also be configured to obtain changed parameters whenever a change event is detected, for example via a trigger. Alternatively or in addition, the system 100 may also be configured check the SUA 1900 at every predetermined time interval to detect any changes. It is contemplated that the system 100 may also be configured to check the SUA 1900 at various system states of the SUA 1900, such as run-time / design phase / batch-mode / on-line vs off-line / simulation states. The system states may correspond to various system life cycles stages of the SUA 1900.

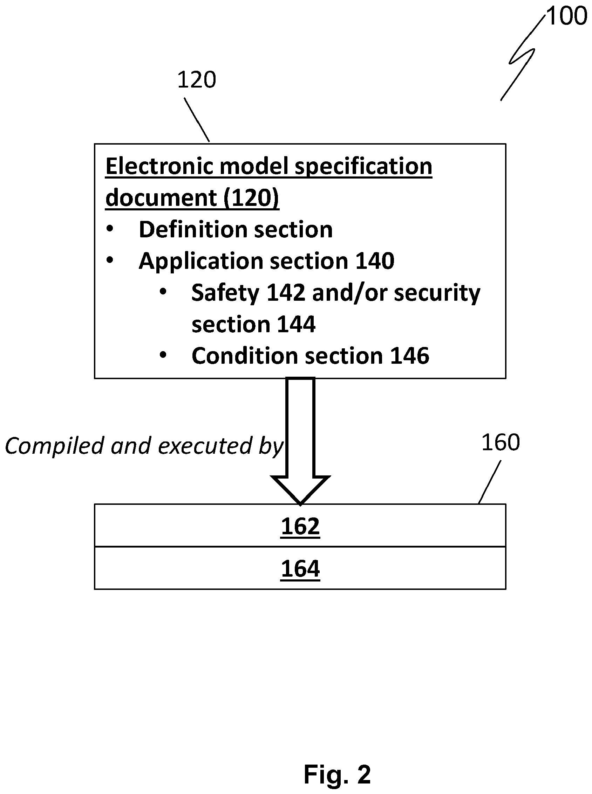

As shown in Fig. 2, the system 100 comprises an electronic model specification 120 for modelling the SUA and associated safety and/or security risks that can arise in the SUA 1900.

It is appreciable that each SUA may be different and there can be a plurality of electronic model specifications 120 created for each SUA depending on operating scenarios or additional components to be added to the SUA. In situations where multiple electronic model specifications 120 are created, each of the plurality of electronic model specifications 120 may be regarded or referred to as a fragment. It is appreciable that multiple fragments of the electronic model specification 120 may be created from different remote sources and combined. Such combination may be performed via referencing in one electronic model specification fragment, one or more other electronic model specification fragments. For example, users such as equipment vendors may choose to make an electronic model specification 120 available through a web resource, such as a uniform resource locator (URL) of their company's domain. The system 100 may be configured to detect any newly added electronic model specification 120 for the SUA 1900 for remodelling. It is appreciable that each electronic model specification fragment shares the same base components as other electronic model specification fragments.

Creation of the electronic model specification 120 may be performed manually (e.g. by risk assessors, equipment vendors, system integrators, risk assessment experts) or automatically (e.g. by simulation engines, or reasoning engines). A semi-automatic process of electronic model specification creation via computer-assisted tools, such as a graphical editor, is also contemplated. In some embodiments, the reasoning engines may include one or more artificial intelligence (AI) engines to model a risk assessment expert(s).

The electronic model specification 120 is created in accordance with a modelling language. The modelling language has a predefined semantic, set of rules and structure to facilitate the modelling of risks. The modelling language defines the way in which one or more properties of an SUA 1900 may be documented in a way so as to meet requirements of expressiveness, correctness, and user understandability. The documented properties may be relevant for risk assessment and/or evaluation.

The modelling language may be regarded as a meta-model that can be realized in various specification language syntaxes. The meta-model may be managed by a component which forms part of an application programming interface (API). An example of a suitable syntax is the Extensible Markup Language (XML), a markup language that defines a set of rules for encoding documents in a format that is both human-readable and machine-readable. Other suitable syntax can include the JavaScript Object Notation (JSON) and the YAML Ain't Markup Language (YAML) syntax.

It is contemplated that the modelling language meta model includes rules that define a valid electronic model specification document in the desired language realization. This means that the modelling of risks, for example a safety hazard is specification language-independent as long as a matching realization parser or syntax analyser is available. Such flexibility allows existing tools, frameworks, and concepts to be utilized under the overall defined structure of the electronic model specification. For example, XML-editors, document validation, XPath and XLink specifications, Resource Description Framework (RDF), etc. can be utilized.

The electronic model specification 120 comprises an application section 140 associated with at least one element of the SUA. The application section 140 provides a context of usual operation of each element of the SUA, including the scope of use of at least one element. For example, where the element of the SUA is a tool such as a chainsaw, the application section 140 provides for a proper use of the tool. For example, a chainsaw for stirring a liquid is not proper use of the chainsaw. The application context therefore needs to be modelled in addition to the element.

The application section 140 includes at least one of a safety section 142 and/or a security section 144 associated with the at least one element; wherein the at least one of a safety section 142 and security section 144 comprises a plurality of risk related properties. The plurality of risk related properties is mappable from a natural language to a system semantic, the system semantic associated with a physical or functional property of the SUA.

As an example of such mapping of natural language to a system semantic, consider the natural expression of a risk related property 'a person is in the path of an automated guided vehicle (AGV)'. While easily understood by a natural person, i.e. a human user documenting such risk, this expression has to be transformed into a machine-readable system semantic that fits the context of the SUA. An example of such mapping may be in modelled in the form as a physical property such as distance between the person and the AGV. Whether the statement 'person is in the path of an AGV' is true can depend on a predefined threshold (e.g. 3 metres - distance apart). Such predefined threshold may change or be affected by other physical properties such as speed or weight of the AGV. For example, if the speed of the AGV is high, a longer distance between the person and the AGV may be defined as the threshold. Likewise, if the load carried by the AGV is heavier, the distance required between the AGV and the person may be longer in order to prevent a collision.

Another example of a mapping is the natural expression of a risk related property 'flying spark'. While sparks may be generated in the normal course of certain operations such as a milling machine, depending on the context of SUA this may contribute to a safety risk in for example an open room without any proper barrier(s) to isolate the flying spark. Whether or not the flying spark will be evaluated to constitute a risk will depend on the modelling or mapping in the form of function property such as whether an appropriate barrier is closed or opened.

The electronic model specification also comprises a condition section 146 specifying at least one condition associated with at least one of a safety breach and a security breach to materialize. The at least one condition comprises at least one of the plurality of risk related property. As an example, a condition may be expressed as a conjunctive list of conditions as shown in Equation 1:

$$(person\_is\_in\_path\_of\_agv) \wedge (agv\_cannot\_brake) \qquad (1)$$

Equation 1 is a simplified example of a hazard model. All elements within Equation (1) must be evaluated to be true for the hazard to take effect or materialize. The risk related property 'person_is_in_path_of_agv' may be defined through the physical and/or functional composition as explained. For example, the "in-path" proposition can simply be modelled as a distance between the person and the path of the AGV that is less than a given threshold. The condition may be modelled in Equation 2, which defines a simplified "in_path_of" proposition based on two parameters (person, AGV). The condition is true when the distance between the person and the path of the AGV is less than a threshold. Symbols prefixed with a $' sign denote variables. It is appreciable that the full hazard description is more elaborate than the example given below is SUA dependent.

$$(in\_path\_of\ \$person\ \$AGV) := (< (distance(location(\$person)(path\_of\ \$AGV))\ \$threshold) \qquad (2)$$

The risk related property 'agv_cannot_brake' or 'agv_cannot_brake_in time' can be a function of the AGV's braking system, floor properties and weight of the AGV. Where there are multiple hazards in an SUA, they may be combined using disjunction (i.e. an 'OR' operation). Any of the hazards may invalidate the conformance of the entire system.

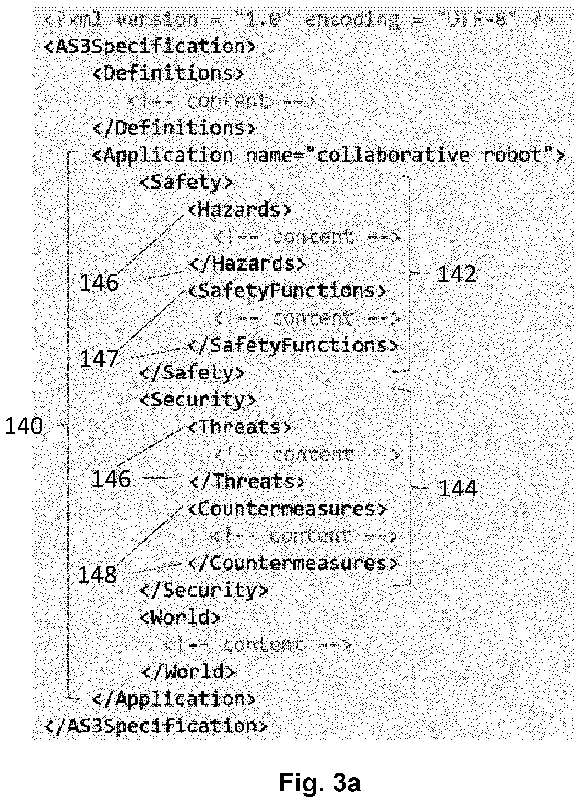

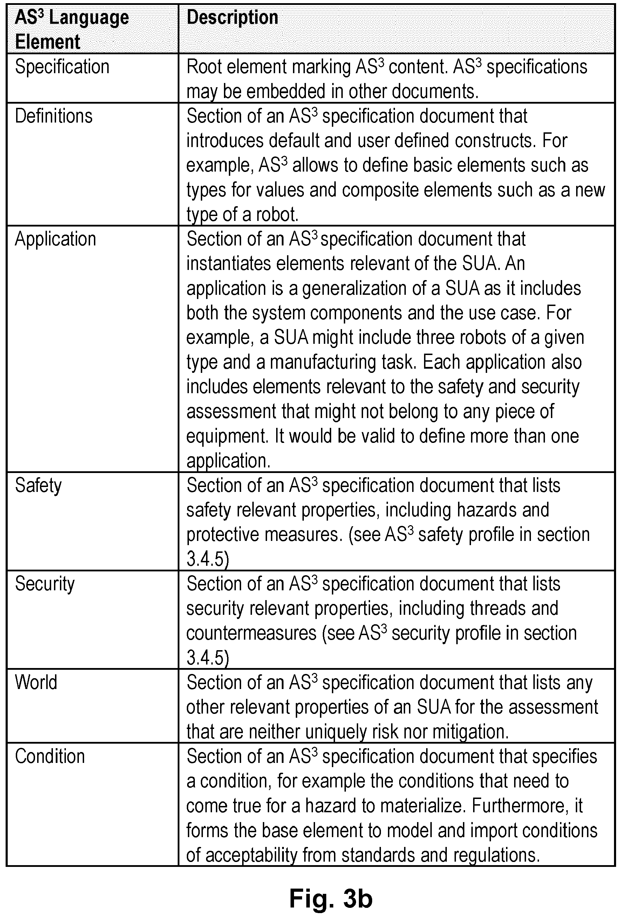

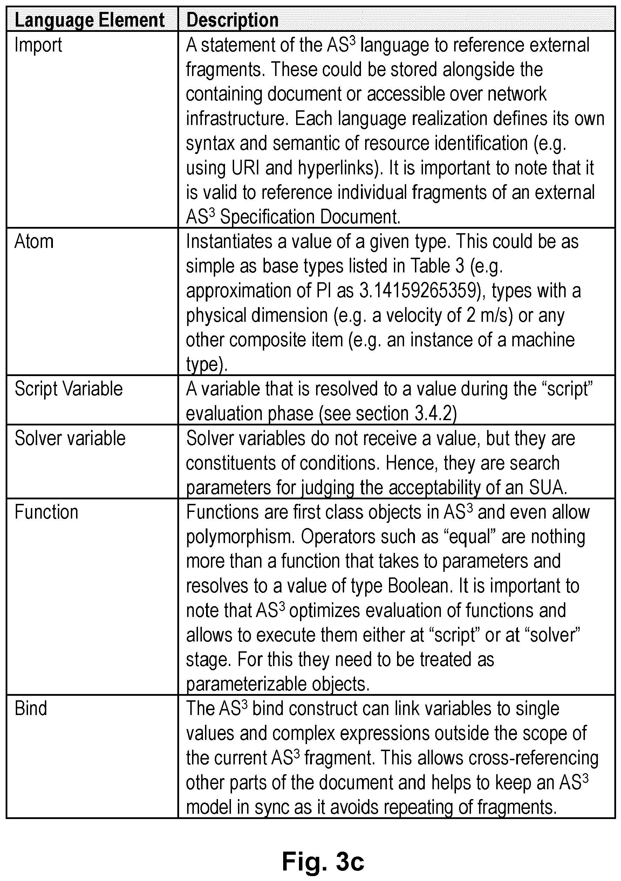

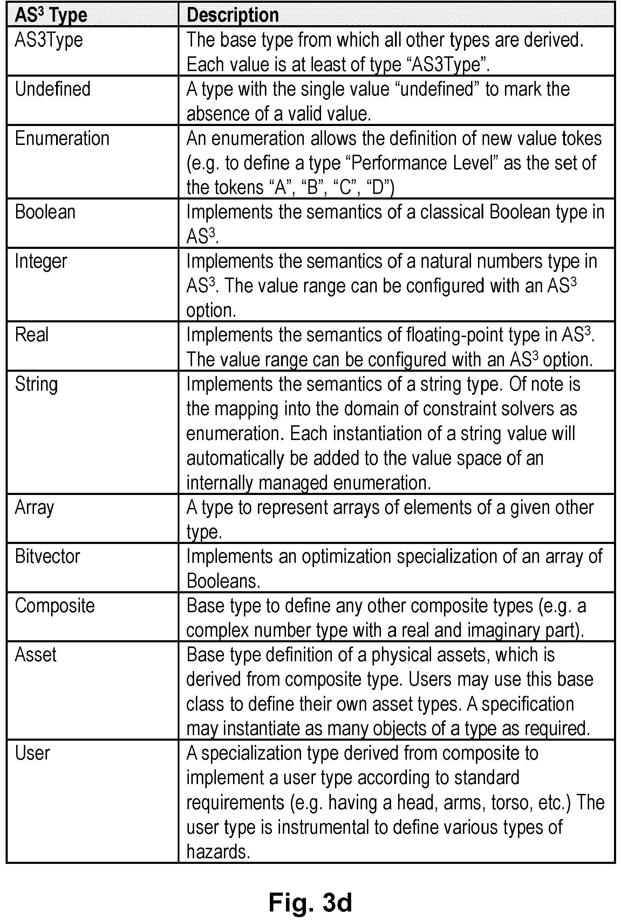

Fig. 3a, 3b, 3c and 3d illustrate various embodiments of the electronic model specification 120. Fig. 3a illustrates an example syntax of the electronic model specification 120 in an XML format, Fig. 3b tabulates top-level elements of the modelling language used to create the electronic model specification, Fig. 3c tabulates the base language elements of the modelling language, and Fig. 3d tabulates the base types of the type system of the modelling language.

Fig. 3b illustrates additional sections of the electronic model specification in addition to the application, safety, security and condition sections. The additional sections may include a definition section and a world section.

The definition section introduces default and user defined constructs. For example, the modelling language may allow the definition of basic elements such as types for values and composite elements such as a new type of a robot.

The world section is the section of the electronic model specification 120 that lists any other relevant properties of an SUA for the assessment that are neither uniquely risk nor mitigation. The world section comprises at least one general property of the SUA 1900. Such general property may not be directly related to any risk of the SUA but can be a physical and/or functional property that can affect the risk assessment of the SUA. A non-limiting example of a general property is gravitational force of earth.

Fig. 3c shows a table of semantic language elements of the electronic model specification 120. One or more of the language elements may be utilized for risk modelling and definition. In particular, the language element import may be used to reference external electronic model specification fragments.

Fig. 3d shows a table of different types as part of the specification language used to create the electronic model specification 120.

A solution to each condition which gives rise to a safety or security hazard, as listed in the condition section or defined within the safety/security sections, may be found within a search or solution space. To this end, the system 100 comprises an evaluation engine 160 to define a search space and to evaluate the condition to a true/false answer. In some embodiments, the evaluation engine 160 includes a script evaluator 162 and a solver evaluator 164. In some embodiments, the evaluation engine may determine the acceptability of SUA based on modelling the risks of the SUA 1900 as an optimization problem to reduce overall computational complexity. Suitable algorithms that may or may not utilize a search space may be contemplated. Non-limiting examples include evolutionary algorithms such as genetic programming/algorithm; regression algorithms; neural networks; fuzzy logic systems, etc.

The script evaluator 162 consolidates the input for the solver evaluator 164. In some embodiments script evaluator 162 operates to reduce the search space of each condition, through, for example, substitution and removing redundant or duplicate solutions. For example, two or more solutions having distance between a person and an AGV less than a predefined threshold of Equation (2) may evaluate the risk related property 'person_is_in_path_of_agv' to be true. The script evaluator 162 operates to remove the redundant solutions from the search space so as to reduce computational resource required for evaluation.

As another example of reducing the complexity or solution space, consider the AGV of Equation (1) and (2). Assume there is a formula/mathematical expression that calculates the braking distance (expressed in metres) of an AGV expressed as a function three parameters: the AGV's current speed, the AGV effective weight which includes the weight of any load carried by the AGV, and the braking force applied (i.e. f (speed, weight, force)). The formula outputs the distance that the AGV will need to come to a complete stop. Assuming there is a condition generated in the constraint solver: (f (speed, weight, force) < 2) meaning that the AGV has to stop within 2 meters of the person. Calculating non-linear functions in the constraint solver may be computationally expensive. The script solver can simplify the formula or completely replace it with the result if all parameters are known. Imagine that f evaluates to 1.5 meters. Then (1.5 < 2) is simply "true". It is appreciable that by simplifying the formulas or completely replacing them, the script solver reduces the number of variables the script solver has to consider.

The solver evaluator 164 evaluates each condition to either a 'true' or a 'false'. If the condition is evaluated to 'true', a risk associated with the corresponding condition exists and the SUA therefore cannot be accepted, i.e. non-conformance is detected. Put in another way, the solver evaluator 164 thus functions as a constraint solver to find an assignment to each risk related property that will make the entire condition to be evaluated to 'true'. The found assignment then automatically constitutes an argument as to why the SUA cannot be accepted.

It is contemplated that the risk model can be represented as a deterministic model, such as, but not limited to, a Satisfiability-Modulo-Theories solver (SMT) model. In addition, the assessment process is formally verifiable.

In some embodiments, the evaluation engine 160 may be configured to receive present or updated parameters from the SUA before each condition is evaluated. In some embodiments, one or more of the risk related property may be mapped into a constraint within the SMT model.

In some embodiments, a protective section 147 may be developed in association with the safety section and a mitigation model 148 may be developed in association with the security section. The protective measures (in the safety domain) or countermeasures (in the security domain) section may be modelled analogously to safety/security risks as conjunctive formulas. The risk modelling language defines mitigation in terms of contradictions to constituents of risks. Using Equation (1) and (2) as examples, a valid safety function can make sure that the AGV is always able to brake or decelerate in time. This could be realized by a safety function that lowers the speed of the AGV to invalidate the "agv_cannot_brake" condition. Another option may be a safety function that addresses the risk related property 'person_is_in_path_of_agv'. The mitigation model can assure that the distance between person and AGV path never becomes too short (i.e. collision avoidance). Such modelling methodology establishes a clear and traceable semantic relationship between protective measures and mitigation that explains why it is valid for a given safety or security hazard.

For the mitigation to be effective, the system 100 makes sure that each protective measure (formula) is satisfiable by itself. This is another important requirement as an invalid protective measure may result in the assessment of the SUA giving a 'false', hence wrongly assessing the SUA to be in conformance even when there is a presence of one or more unmitigated risks that remain in the system. It is appreciable that the mitigation model may be used in addition with the risk model to evaluate conformance of the SUA.

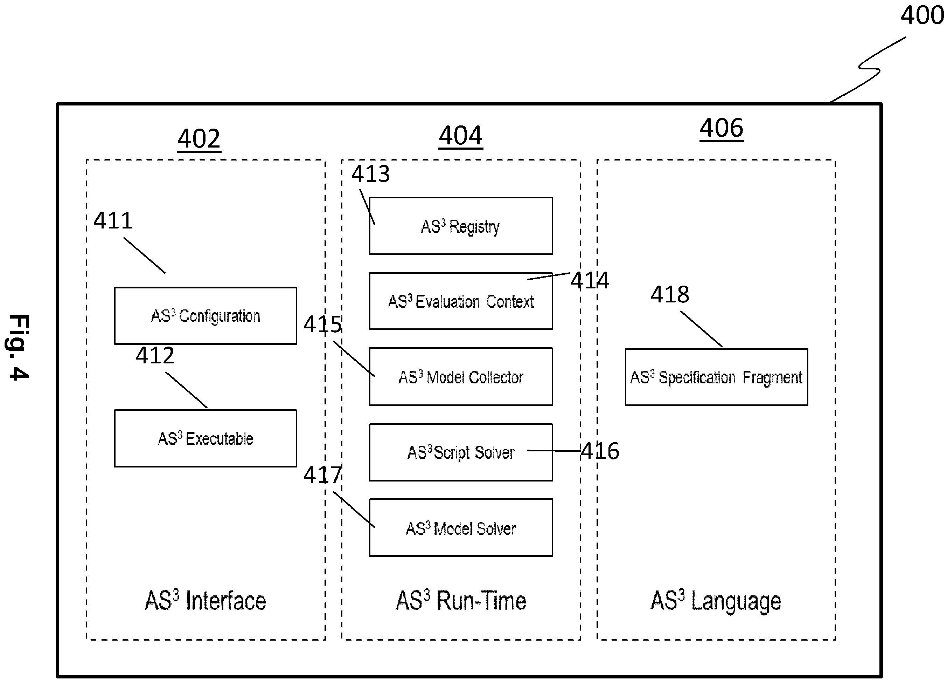

In some embodiments, the formalism of the electronic model specification may be based on components listed in Fig. 4, in the form of an application programming interface (API) 400. The API 400 is organised into three categories: (1) interface 402, (2) run-time 404, and (3) language 406.

Components in the interface category define how the electronic model specification 120 and evaluation engine 160 is packaged, used, and interfaced with. The system configuration includes a variety of settings, including environment settings such as modelling language configuration 411, interpretation of input, execution paths, logging levels, authentication, network settings and others. The executable 412 is the binary executable compiled for the target platform (i.e. SUA 1900) of execution. Several modes of interaction are contemplated, including execution as command line tool and as web service. Furthermore, the executable as a library can be embedded in, or called by, supplementary tools such as system design tools or manufacturing execution systems (MES).

Components in the Run-Time category 404 enable the execution of the system 100, i.e. they implement the algorithms of the system 100 including receiving parameters from the SUA, generating a risk model associated with the SUA, and generating a search space. A registry component 413 controls the set of language elements supported during an evaluation run. The registry component 413 allows the generalization over language elements by alias and by type, a core feature for the extendibility of the language and methodology. The Context component 414 implements an execution scoping mechanism that includes defined types, variables, and functions. A model collector component 415 implements the algorithm to create a risk model associated with an SUA, which is evaluated by two evaluation passes, implemented through the script solver 416 and the model solver 417, respectively. The result of the evaluation is formatted and passed through the configured interface back to the caller.

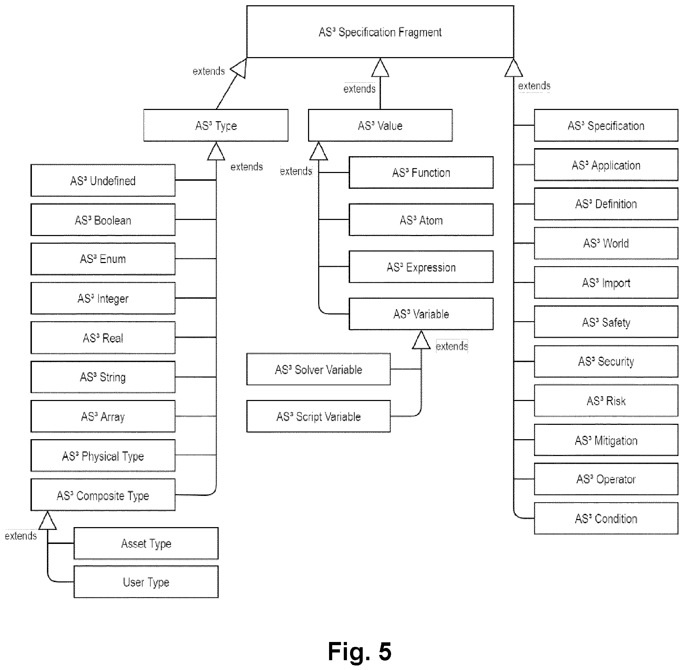

Components of the modelling language category 406 implement the risk modelling language itself. A single electronic model specification fragment 418 is the root component from which all others are derived in an object-oriented fashion. An embodiment of a simplified start of the inheritance hierarchy tree is shown in Figure 5. Each construct of the modelling language is realized by a specialization of an electronic model specification fragment. Each component defines its contribution to a system model and a matching interpreter to construct a result for the evaluation.

Fig. 5 shows an embodiment of the modelling language components forming the structure of the electronic model specification 140 or a part thereof (i.e. fragment), based on object oriented principles. Fig. 5 also depicts the relationships, including inheritance relationships, between different components in the electronic model specification 140. It is to be appreciated that arrow hats (shown as △) are only overlapping to simplify the overview. Each inheritance relationship should be understood as a parallel line. Distinguishing features of the inheritance relationships include the following:

The type system is completely configurable to suit the needs of an SUA. This goes as far as the ability to redefine what "Boolean" type is (e.g. true/false, on/off, one/zero, etc.) It is contemplated that any type can be redefined, modified or excluded. The rigor of the modelling language makes sure that no invalid statements result from this flexibility.

The type 'system' is not limited to the types that typical constraint solvers allow. This is noteworthy for the modelling flexibility, expressiveness and usability of the system 100. Theoretically, all risk assessors could be taught to express an SUA model in the domain of constraint solvers. However, this may be impractical and counterproductive as many inconsistencies can arise. Among the many ways risk assessment can be mapped to constraint solvers, the present disclosure of mapping a risk related property to a system semantic and a conjunctive list of conditions, and subsequently into a constraint space, makes sure that the various expressions remain compatible and interoperable.

Two or more types of variables may be contemplated to model the different evaluation steps. Script variables (for subsequent reduction of the solution or search space via the script solver) may hold local or remote values, generalizing over the concept of a variable. Script variables hold a value. Solver variables do not hold a single value but reference a family of possible assignments. Hence, they are the search parameters for the model evaluation step.

It is contemplated that safety and security concepts can share many common features (e.g. the concepts of risk and mitigation) but are also specialized to model their distinguishing differences. For example, safety functions need to conform to a target performance level and safety integrity level, while countermeasures need to conform to a security level.

The hierarchy is extendible, enabling the features of the API 400, modules, libraries, and graphical editors to assist in the process of creating the electronic model specification.

In some embodiments, software extensions may be defined to extend the functionality of the base modelling language. There are at least two major categories of extension: (1) Content modelled in the modelling language itself, and (2) extensions of the modelling language using the API 400. The first category is referred to as modules, and the second may be referred to as libraries. Modules are more portable but are limited to the configured constructs. Libraries fully subsume modules and additionally allow extension to the language.

Modules can be a way to codify existing standards and dynamically import them in the evaluation process. Hence, if an SUA should conform to a given standard, a user, who may be an assessor, may simply import the respective module(s). Standards are typically published by international standardization organizations such as ISO and IEC. For example, analyzing the requirements for safety related control systems in ISO 10218-2, such requirements, as shown in Equation (3), may be translated to an electronic model specification fragment via formation of conjunctive and disjunctive formulas as discussed.

$$(No\_SingleFault\_may\_lead\_to\_loss\_of\_safety\_function) \wedge$$

$$(SingleFault\_shall\_be\_detected\_before\_next\_demand) \wedge$$

$$(SingleFault\_triggers\_safety\_function\_and\_maintain\_until\_fault\_is\_corrected) \wedge$$

$$(All\_foreseeable\_faults\_shall\_be\_detected) \tag{3}$$

The target performance requirement can be expressed in the modelling language as well in the following syntax:

```
<SafetyRelatedControlSystem >

    <PerformanceLevel>D</PerformanceLevel>
    <StructureCategory>3</StructureCategory>
    <SafetyIntegrityLevel>2</SafetyIntegrityLevel>

<SafetyRelatedControlSystem >
```

Based on the aforementioned constructs, the modelling language defines structure and content of safety and security profiles for components of an SUA. For example, a safety profile may include one or more of the following: type of components, safety targets or thresholds, safety measure classification, safety measure properties, reliability requirements (Performance level or Reliability level for mechanical parts), availability over time.

A security profile may include one or more of the following: type of component, security targets (e.g. confidentiality, integrity, availability), security measure classification, security measure properties, security level requirements, availability over time.

While it is appreciable that an electronic model specification can be created using a rudimentary text editor, depending on the chosen realization of the language, tool support can be introduced to ease the burden of a user. For example, there are several tools available to edit XML, JSON, and YAML documents, including syntax checkers, validation, and graphical representations.

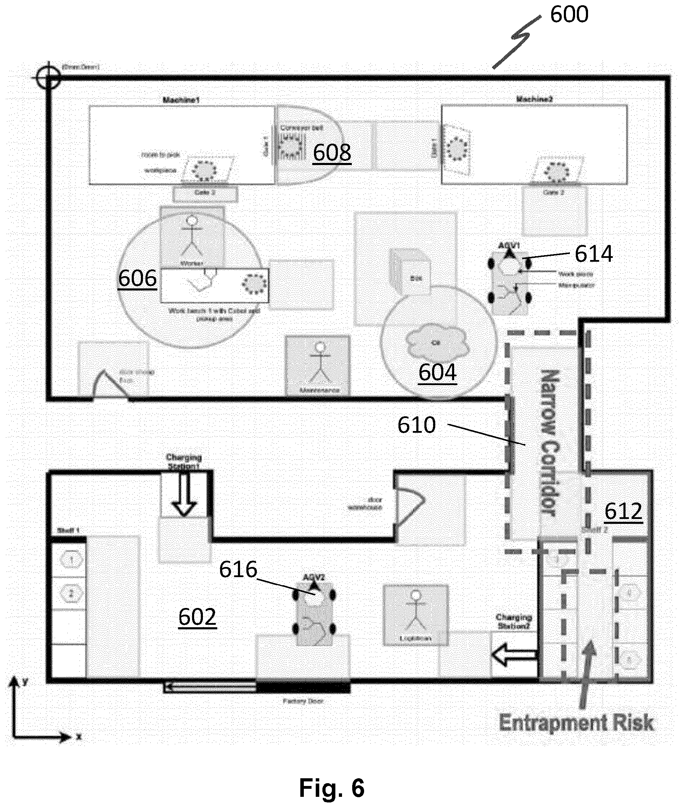

Fig. 6 shows an example of a specialized editor in the form of a computer aided design tool 600 provided to a user in assisting the modelling and assessment/evaluation of risks. Fig. 6 illustrates an example prototype visualization of a 2D editor for managing a factory layout.

The 2D editor is utilized to create and manage the electronic model specification document. Using the 2D editor, a user can drag and drop elements of the SUA, such as equipment onto a space 602. In the background the editor manages an electronic model specification document and adds required fragments to the SUA specification. Figure 6 depicts a reasonably complex application with several machines, a robot, warehouses, shelves, personnel, and AGVs. The marked areas 604, 606 and 608 represent hazard zones that are imported or explicitly specified for the application. Marked area 604 represents an oil puddle, marked area 606 represents a work bench and marked area 608 represents a conveyor belt.

An example of the effectiveness of the system 100 can be observed in the narrow corridor 610. In case only one AGV is present in the factory, the only area with an entrapment risk is "shelf 2" 612. If a person enters the "shelf2" area 612 and an AGV 614 enters after the personnel, the personnel would have no way to get out of shelf2 area 612, and therefore no escape route. This represents an unacceptable risk. Such an unacceptable risk can be mitigated by an entry control safety function to the shelf. However, upon adding another AGV 616 of the same type as the first AGV 614, a new hazard zone appears in the corridor 610. This may be surprising at first since only acceptable and already certified systems are participating. However, there is a possibility of new emerging hazard in which a person may be trapped between two AGVs along the corridor 610. For a human assessor, it might be difficult to identify such emerging hazards of multiple interacting systems.

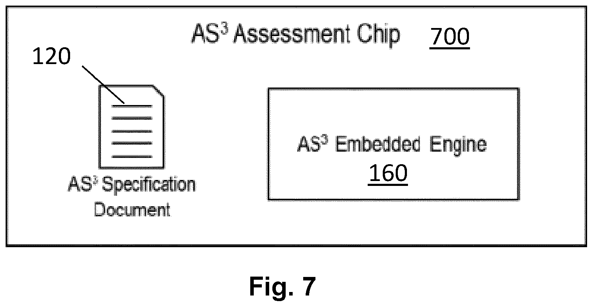

In some embodiments, the system 100 may be realised directly in hardware, for example via the use of field-programmable gate array (FPGA) for composable safe and secure systems. Each critical component of a system could be embedded with or connected to an integrated circuit (IC) chip 700 (see Fig. 7). The IC chip 700 comprises the electronic model specification and an embedded engine configured to perform the functions of the evaluation engine 160. The electronic model specification can be compiled by the evaluation engine 160 at run time to form a risk model which can contain all relevant hazards and mitigation of the component, including its safety and security profile.

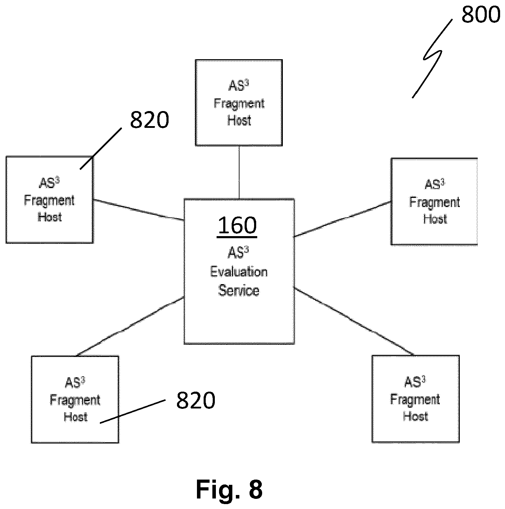

In some embodiments, the system 100 can also be deployed as a service over a network 800 (see Fig. 8). A node in the network 800 can be hosting the evaluation engine 160. The node provides an entry point for the execution of the risk evaluation. The electronic model specification 120 and associated fragments may be hosted by various network nodes 820 in the network 800. A non-limiting example of a node 820 is a vendor's website. The system 100 service engine 160 may consolidate or combine all the electronic model specification fragments. The service engine can provide judgements for received documents on demand.

In some embodiments, the system can be realized as a plugin for a design tool to assess conformance of the SUA throughout various phases of the design (see for example the editor of Fig. 6).

In normal operations, the system 100 may not be considered or offered as an active safety function and/or security countermeasure in operation to ensure independence with respect to the SUA. However, it is contemplated that the system 100 has the capabilities to provide useful information of existing gaps to be fixed by the user in a passive manner.

Notwithstanding the above, the system 100 can potentially be raised to the level of an active safety function and actively assure safety and security of an SUA where independence may still be achieved.

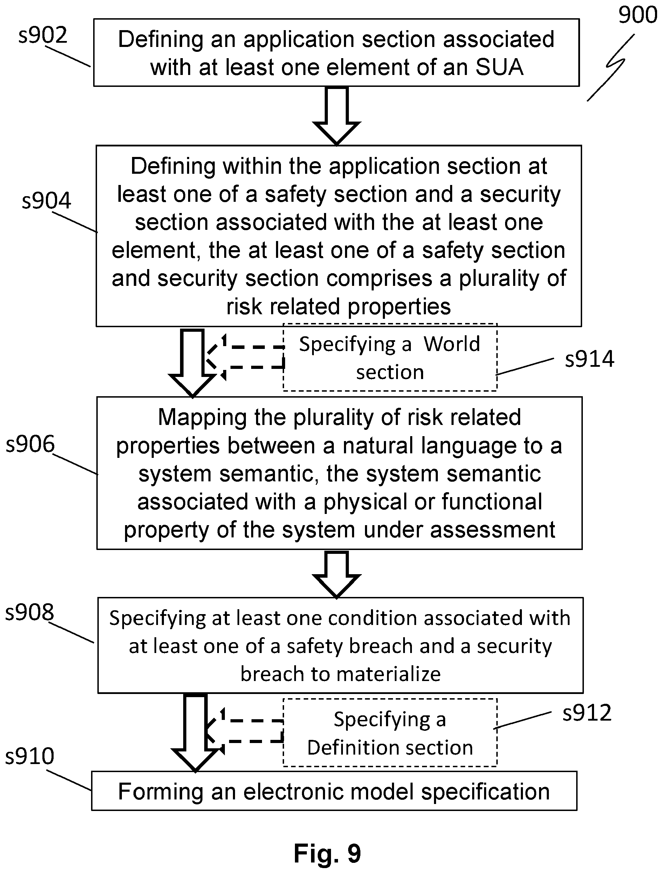

According to another aspect of the disclosure there is a method for modelling risks associated with a SUA. Fig. 9 shows an embodiment of the method 900, comprising the steps of: (a.) defining an application section associated with at least one element of the SUA (step s902); (b.) defining within the application section at least one of a safety section and a security section associated with the at least one element, the at least one of a safety section and/or security section comprises a plurality of risk related properties (step s904); (c.) mapping the plurality of risk related properties between a natural language to an system semantic, the system semantic associated with a physical or functional property of the SUA (step s906); (d.) specifying at least one condition associated with at least one of a safety breach and a security breach to materialize (step s908); and forming an electronic model specification (step s910).

In some embodiments, the method 900 may include the step of specifying a definition section defining a plurality of general elements associated with the SUA (step s912).

In some embodiments, the step of defining an application section further includes the step of specifying a world section (step s914), the world section comprises at least one non-risk related property *per se.* Examples of a non-risk related property include law of physics, environmental parameters such as temperature and pressure etc. Although non-related related properties may not be risk related property, they may be utilized as threshold for risks to materialize. For example, a temperature threshold may be set such that exceeding the temperature threshold will result in the materialization of an explosion risk.

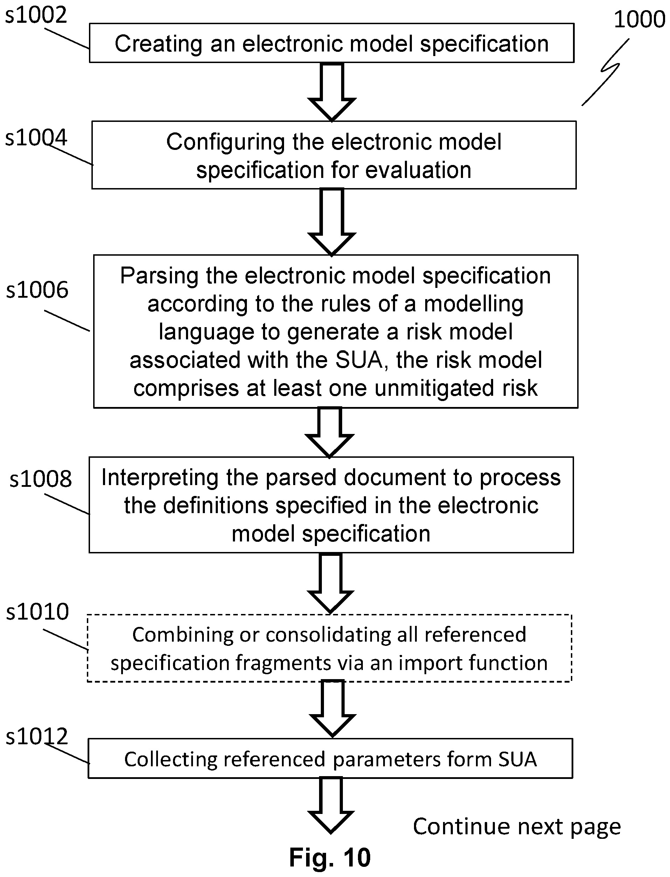

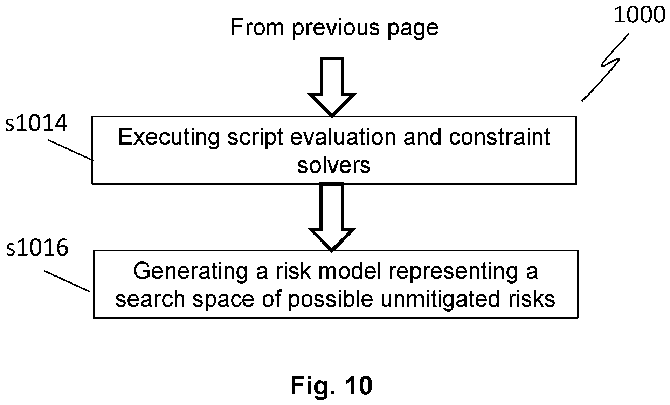

The method 900 may be supplemented with a method 1000 for assessing risks associated with a SUA (SUA). With reference to Fig. 10, the method 1000 commences with the step of generating or creating an electronic model specification in accordance with method 900 (step s1002). The method 1000 then proceeds to a step of configuring the system 100 (step s1004). The configuration determines the boundary conditions of the execution of the evaluation (e.g. which features are being used in the execution of the evaluation, types of interfaces that are available, mode of execution, etc.)

After the configuration is done, the next step involves the step of parsing the electronic model specification documents according to the rules of the modelling language (step s1006) to generate a specification 120 associated with the SUA. The parsing step includes a step of interpreting the parsed document to process the definitions specified in the electronic model specification (step s1008). The structure and implementation of the modelling language results in a modular and extendible specification. For example, the electronic model specification may define custom types to model an SUA. The definitions might also modify how values are being interpreted (e.g. metric vs imperial unit system). The parsing step may also include the step of combining or consolidating all referenced specification fragments via an import function (step s1010). It is appreciable that the referenced electronic model specification fragments may be locally available or may be remotely available. For example, equipment vendors might choose to make an electronic model specification (fragment) available through a unique URI of their company's domain. Any loaded fragment will be recursively evaluated using the same process. It is appreciable that if there is no specification fragment to be imported, the consolidating step may be skipped.

After all relevant (or necessary) electronic model specifications have been imported, the most generic version of the risk model is available. The risk model then undergoes script evaluation and solver evaluation to identify one or more unmitigated risks associated with the SUA. The following steps s1012 and s1014 facilitate adaptive and optimized risk assessment. First, all referenced parameters from an SUA are collected (step s1012) so that the most current or recent parameters of the SUA are accounted for at run time. These might include, among others, current operating conditions, tasks to execute, and derived or predicted parameters from a simulation. Once the data collection process has completed all derived expression (conjunctive formulas) can be processed via script evaluation and constraint solvers (step s1014). For example, an expression "total weight of an AGV" may be an expression of the sum of its components and its current transport load. The "script" evaluation step first narrow down computational complexity associated with, for example, whether the total weight of the AGV exceeds a predetermined constraint (e.g. weight limit) before solver evaluation. Traditional constraint solvers suffer from a huge increase of state space when applied to large, real-world problems. The "script" evaluation phase reduces the complexity for constraint solvers.

After the script and solver evaluation, a deterministic model, such as an SMT model, is generated (step s1016) which represents the input for the solver to find unmitigated risks. For example, the model solver might find an assignment of solver variables that would constitute an unacceptable possibility, which constitutes a hazard that can inflict harm. (e.g. "the user stands in-front of the machine" AND "the machine is on" AND "the door is open" AND "user has one hand free" THEN "user might get cut by rotating equipment"). The results of the model solver phase are parsed, and an evaluation report is generated. The report generation is flexible to cater to the needs of further automatic processing (e.g. by design tools) or for interpretation of a human assessor.

The method 900 and/or method 1000 may be implemented on a computer readable medium, such as one or more computer devices. As an example, the generation of an electronic model specification via a text editor or graphical editor may be performed on a computing device and the assessing steps in method 1000 implemented on a host server. In some embodiments, to mitigate possibilities of tempering of evaluation process and results, the method 900 and/or method 1000 may be implemented in a blockchain network.

It is contemplated that the system 100 and method 900, 1000 may be used to support various use cases as follows:

Risk assessment- The system 100 can be integrated in the traditional workflow of safety and security assessment. It replaces the way risks (hazards and/or threats) and mitigations or countermeasures are documented and formalizes and restructures the risk assessment process. Instead of human-only readable documentation, the system 100 formalizes the documentation and provides a list of conjunctive formulas such that automatic assessment becomes feasible. It is contemplated that the system 100 can be part of the R&D activities for the design and manufacturing of components, products and sub-systems destined for IIoT contexts.

Run-time risk monitor- The system 100 can be deployed alongside an already validated system application in terms of safety and security to dynamically re-evaluate conformance of the SUA when parameters of the SUA changes. The main value is derived from optimizations that become possible due to parameterized assessments and relaxing of worst-case assumptions. Even if the system 100 does not accept an SUA, the operator might still decide to run it anyway at his own discretion and taking responsibility of the flagged risks.

Black box assessment- The system 100 may be used in a black-box assessment mode. In this mode, part of the electronic model specification is either remotely available and/or may be encrypted, such as binary encrypted. A user of a piece of equipment that forms part of an original SUA electronic model specification might decide to modify a part of the equipment. Such modifications may include the replacement of one or more motors, or adding a new piece of equipment. However, the user may not have access to the risk assessment of the original SUA. This might be for reasons of intellectual property protection, or simple economic reasons. The system 100 can allow the user to proceed anyway. Using the modelling language, the user can create an electronic model specification fragment containing only his changes. As the electronic model specification fragment includes additional conjunctive conditions representing the risks attributed by the new equipment, the evaluation engine 160 can re-evaluate the entire system 100 with the newly added electronic model specification fragment, without disclosing any of the details of the original system 100. For example, if the modification may be rejected because the modification which includes a new motor draws more power, which in turn increases the temperature of the power supply, which then creates an unmitigated risk. The original SUA vendor may define level of details for the assessment report. If the vendor does not want to give away specification of the power supply, the system could simply be rejected without further explanation.

Assistive tool- The method 900 for risk modelling and/or the method 1000 for risk assessment may be integrated with existing system design tools. The computer-aided tool illustrated in Fig. 6 may be used as an example. At various stages of system design, the system 100 may be invoked to gather insights of the SUA's hypothetical acceptability. The assessment will likely be only indicative as the electronic model specification 120 at various stages may not yet be complete and therefore not approved by a TIC expert. In some embodiments, the methods 900 and 1000 will only be able to judge that an SUA 1900 has an unmitigated risk but will not be able to propose a solution. It will, however, be able to judge the solution as far as it has been modelled based on the modelling language.

Scenario testing and What-if analysis- By offering a parameterized conformity assessment, the system 100 and methods 900, 1000 can be used to model and evaluate different what-if scenarios and explore implications of modifications for SUA acceptability. Such studies could further support the improvement or optimization of the system design, e.g. by highlighting if acceptability is only achieved in a narrow parameter space.

In some embodiments, the method 900 and/or the method 1000 can be encoded in the form of software computer codes or computer programs. The computer programs include processor-executable instructions that are stored on at least one non-transitory computer-readable medium. The computer programs may also include or rely on stored data. The computer programs may encompass a basic input/output system (BIOS) that interacts with hardware of the special purpose computer, device drivers that interact with particular devices of the special purpose computer, one or more operating systems, user applications, background services, background applications, etc.

**Claims**

1. A system (100) for modelling and assessment of risks for a system under assessment, SUA, (1900), **characterized in that** the system (100) comprises:

   a) a plurality of electronic model specification fragments in a modelling language residing at one or more first network nodes,

      i) wherein the modelling language includes a plurality of rules that define each electronic model specification fragment in a desired language realization; and
      ii) wherein each electronic model specification fragment comprises:

         1) a definition section including default constructs and user defined constructs;
         2) an application section (140),

            a) wherein the application section (140) includes at least one element of the SUA (1900);
            b) wherein the at least one element includes at least one of a safety section (142) and a security section (144);
            c) wherein the at least one of a safety section (142) and security section (144) comprises a plurality of risk related properties; the plurality of risk related properties mapped from a natural language to a system semantic; and
            d) wherein the system semantic includes a physical or functional property of the SUA (1900); and

         3) a condition section (146) specifying at least one condition for at least one of a safety risk and a security risk to materialize; wherein the at least one condition comprises at least one of the plurality of risk related properties;

   b) a computer-assisted tool to manage the plurality of electronic model specification fragments to create an electronic model specification (120) of the SUA (1900); and
   c) an evaluation engine (160) residing at a second network node, the evaluation engine (160) configured to evaluate, for the electronic model specification (120) of the SUA (1900), the at least one condition to determine if an unmitigated risk exists,

      i) wherein the evaluation engine (160) is configured to receive a set of reference parameters from the SUA (1900) to define a search space for the at least one condition;
      ii) wherein the defined search space represents a set of solutions that comprises one or more unmitigated risks; and
      iii) wherein the system (100) is arranged in communication with the SUA (1900) to receive the reference parameters from the SUA (1900) and the SUA (1900) is an industrial asset including a production system or a manufacturing system.

2. The system (100) of claim 1, wherein the defined search space is reduced by substitution and removing redundant or duplicate solutions.

3. The system (100) of claim 1 or 2, wherein the application section (140) comprises a world section, the world section comprises at least one general property .

4. The system (100) of any of the preceding claims, wherein each of the plurality of electronic model specification fragments is associated with at least one of an equipment, a facility, an infrastructure, and a vehicle of the SUA (1900).

5. The system (100) of any of claims 1 to 4, wherein the search space is represented as a deterministic model; optionally the deterministic model is a Satisfiability-Modulo-Theories solver model.

6. The system (100) of any of the preceding claims, wherein the computer-assisted tool is one of a text editor, a graphical editor, and a 2D editor.

**Patentansprüche**

1. System (100) zum Modellieren und Bewerten von Risiken für ein zu bewertendes System, SUA, (1900), **dadurch gekennzeichnet, dass** das System (100) Folgendes umfasst:

   a) eine Vielzahl von Fragmenten einer elektronischen Modellspezifikation in einer Modellierungssprache, die an einem oder mehreren ersten Netzknoten gespeichert sind,

   i) wobei die Modellierungssprache eine Vielzahl von Regeln enthält, die jedes Fragment einer elektronischen Modellspezifikation in einer gewünschten Sprachrealisierung definieren; und
   ii) wobei jedes Fragment einer elektronischen Modellspezifikation Folgendes umfasst:

   1) einen Definitionsabschnitt, der Standardkonstruktionen und benutzerdefinierte Konstruktionen enthält;
   2) einen Anwendungsabschnitt (140),

   a) wobei der Anwendungsabschnitt (140) mindestens ein Element des SUA (1900) enthält;
   b) wobei das mindestens eine Element mindestens einen von einem Sicherheitsabschnitt (142) und einem Schutzabschnitt (144) enthält;
   c) wobei der mindestens eine von einem Sicherheitsabschnitt (142) und einem Schutzabschnitt (144) eine Vielzahl von risikobezogenen Eigenschaften umfasst; wobei die Vielzahl von risikobezogenen Eigenschaften von einer natürlichen Sprache auf eine Systemsemantik abgebildet wird; und
   d) wobei die Systemsemantik eine physikalische oder funktionale Eigenschaft des SUA (1900) enthält; und

   3) einen Bedingungsabschnitt (146), der mindestens eine Bedingung für ein Eintreten von mindestens einem von einem Sicherheitsrisiko und einem Schutzrisiko spezifiziert; wobei die mindestens eine Bedingung mindestens eine von der Vielzahl von risikobezogenen Eigenschaften umfasst;

   b) ein computergestütztes Instrument zum Verwalten der Vielzahl von Fragmenten einer elektronischen Modellspezifikation, um eine elektronische Modellspezifikation (120) des SUA (1900) zu erstellen; und
   c) eine Auswertungsmaschine (160), die an einem zweiten Netzknoten gespeichert ist, wobei die Auswertungsmaschine (160) dazu konfiguriert ist, für die elektronische Modellspezifikation (120) des SUA (1900) die mindestens eine Bedingung auszuwerten, um zu bestimmen, ob ein ungemindertes Risiko besteht,

   i) wobei die Auswertungsmaschine (160) dazu konfiguriert ist, einen Satz von Referenzparametern von dem SUA (1900) zu empfangen, um einen Suchraum für die mindestens eine Bedingung zu definieren;
   ii) wobei der definierte Suchraum einen Satz von Lösungen darstellt, der ein oder mehrere ungeminderte Risiken umfasst; und
   iii) wobei das System (100) in Kommunikation mit dem SUA (1900) angeordnet ist, um die Referenzparameter von dem SUA (1900) zu empfangen, und das SUA (1900) ein gewerbliches Wirtschaftsgut ist, das ein Produktionssystem oder ein Fertigungssystem enthält.

2. System (100) nach Anspruch 1, wobei der definierte Suchraum durch Substitution und Entfernen redundanter oder doppelter Lösungen verringert wird.

3. System (100) nach Anspruch 1 oder 2, wobei der Anwendungsabschnitt (140) einen Weltabschnitt umfasst, wobei der Weltabschnitt mindestens eine allgemeine Eigenschaft umfasst.

4. System (100) nach einem der vorhergehenden Ansprüche, wobei jedes der Vielzahl von Fragmenten einer elek-

EP 4 027 204 B1

tronischen Modellspezifikation mindestens einem von einem Ausstattungsgegenstand, einer Anlage, einer Infrastruktur und einem Fahrzeug des SUA (1900) zugeordnet ist.

**5.** System (100) nach einem der Ansprüche 1 bis 4, wobei der Suchraum als ein deterministisches Modell dargestellt ist, wobei das deterministische Modell optional ein Erfüllbarkeit-Modulo-Theorien-Solver-Modell ist.

**6.** System (100) nach einem der vorhergehenden Ansprüche, wobei das computergestützte Instrument eines von einem Texteditor, einem grafischen Editor und einem 2D-Editor ist.

**Revendications**

**1.** Système (100) de modélisation et d'évaluation de risques pour un système en cours d'évaluation, SUA, (1900), **caractérisé en ce que** le système (100) comprend :

a) une pluralité de fragments de spécification de modèle électronique dans un langage de modélisation résidant au niveau d'un ou plusieurs premiers noeuds de réseau,

i) dans lequel le langage de modélisation comprend une pluralité de règles qui définissent chaque fragment de spécification de modèle électronique dans une réalisation de langage souhaitée ; et
ii) dans lequel chaque fragment de spécification de modèle électronique comprend :

1) une section de définition comprenant des constructions par défaut et des constructions définies par l'utilisateur ;
2) une section d'application (140),

a) dans lequel la section d'application (140) comprend au moins un élément du SUA (1900) ;
b) dans lequel l'au moins un élément comprend au moins l'une d'une section de protection (142) et d'une section de sécurité (144) ;
c) dans lequel l'au moins une d'une section de protection (142) et d'une section de sécurité (144) comprend une pluralité de propriétés liées au risque ; la pluralité de propriétés liées au risque mappées d'un langage naturel à une sémantique de système ; et
d) dans lequel la sémantique de système comprend une propriété physique ou fonctionnelle du SUA (1900) ; et

3) une section de condition (146) spécifiant au moins une condition pour qu'au moins l'un d'un risque de protection ou d'un risque de sécurité se matérialise ; dans lequel l'au moins une condition comprend au moins l'une de la pluralité de propriétés liées au risque ;

b) un outil assisté par ordinateur pour gérer la pluralité de fragments de spécification de modèle électronique afin de créer une spécification de modèle électronique (120) du SUA (1900) ; et
c) un moteur d'évaluation (160) résidant au niveau d'un seconde noeud de réseau, le moteur d'évaluation (160) configuré pour évaluer, pour la spécification de modèle électronique (120) du SUA (1900), l'au moins une condition afin de déterminer si un risque non atténué existe,

i) dans lequel le moteur d'évaluation (160) est configuré pour recevoir un ensemble de paramètres de référence du SUA (1900) afin de définir un espace de recherche pour l'au moins une condition ;
ii) dans lequel l'espace de recherche défini représente un ensemble de solutions qui comprennent un ou plusieurs risques non atténués ; et
iii) dans lequel le système (100) est agencé en communication avec le SUA (1900) pour recevoir les paramètres de référence du SUA (1900) et le SUA (1900) est un actif industriel comprenant un système de production ou un système de fabrication.

**2.** Système (100) selon la revendication 1, dans lequel l'espace de recherche défini est réduit par substitution et suppression des solutions redondantes ou en double.

**3.** Système (100) selon la revendication 1 ou 2, dans lequel la section d'application (140) comprend une section universelle, la section universelle comprend au moins une propriété générale.

4. Système (100) selon l'une quelconque des revendications précédentes, dans lequel chacun de la pluralité de fragments de spécification de modèle électronique est associé à au moins un parmi un équipement, une installation, une infrastructure et un véhicule du SUA (1900).

5. Système (100) selon l'une quelconque des revendications 1 à 4, dans lequel l'espace de recherche est représenté comme un modèle déterministe ; éventuellement, le modèle déterministe est un modèle solveur Satisfaisabilité-Modulo-Théories.

6. Système (100) selon l'une quelconque des revendications précédentes, dans lequel l'outil assisté par ordinateur est l'un parmi un éditeur de texte, un éditeur graphique et un éditeur 2D.

1900

System Under Assessment
(SUA)

models and reads
parameters of

is independent from

judges safety and or
security of

Adaptive Safety and
Security System (AS$^3$)

Fig. 1

100

120

**Electronic model specification document (120)**
- **Definition section**
- **Application section 140**
  - **Safety 142 and/or security section 144**
  - **Condition section 146**

*Compiled and executed by*

160

**162**

**164**

**Fig. 2**

```
<?xml version = "1.0" encoding = "UTF-8" ?>
<AS3Specification>
    <Definitions>
        <!-- content -->
    </Definitions>
    <Application name="collaborative robot">
        <Safety>
            <Hazards>
                <!-- content -->
            </Hazards>
            <SafetyFunctions>
                <!-- content -->
            </SafetyFunctions>
        </Safety>
        <Security>
            <Threats>
                <!-- content -->
            </Threats>
            <Countermeasures>
                <!-- content -->
            </Countermeasures>
        </Security>
        <World>
            <!-- content -->
        </World>
    </Application>
</AS3Specification>
```

140  142  146  147  144  146  148

**Fig. 3a**

| AS³ Language Element | Description |
|---|---|
| Specification | Root element marking AS³ content. AS³ specifications may be embedded in other documents. |
| Definitions | Section of an AS³ specification document that introduces default and user defined constructs. For example, AS³ allows to define basic elements such as types for values and composite elements such as a new type of a robot. |
| Application | Section of an AS³ specification document that instantiates elements relevant of the SUA. An application is a generalization of a SUA as it includes both the system components and the use case. For example, a SUA might include three robots of a given type and a manufacturing task. Each application also includes elements relevant to the safety and security assessment that might not belong to any piece of equipment. It would be valid to define more than one application. |
| Safety | Section of an AS³ specification document that lists safety relevant properties, including hazards and protective measures. (see AS³ safety profile in section 3.4.5) |
| Security | Section of an AS³ specification document that lists security relevant properties, including threads and countermeasures (see AS³ security profile in section 3.4.5) |
| World | Section of an AS³ specification document that lists any other relevant properties of an SUA for the assessment that are neither uniquely risk nor mitigation. |
| Condition | Section of an AS³ specification document that specifies a condition, for example the conditions that need to come true for a hazard to materialize. Furthermore, it forms the base element to model and import conditions of acceptability from standards and regulations. |

## Fig. 3b

| Language Element | Description |
|---|---|
| Import | A statement of the AS$^3$ language to reference external fragments. These could be stored alongside the containing document or accessible over network infrastructure. Each language realization defines its own syntax and semantic of resource identification (e.g. using URI and hyperlinks). It is important to note that it is valid to reference individual fragments of an external AS$^3$ Specification Document. |
| Atom | Instantiates a value of a given type. This could be as simple as base types listed in Table 3 (e.g. approximation of PI as 3.14159265359), types with a physical dimension (e.g. a velocity of 2 m/s) or any other composite item (e.g. an instance of a machine type). |
| Script Variable | A variable that is resolved to a value during the "script" evaluation phase (see section 3.4.2) |
| Solver variable | Solver variables do not receive a value, but they are constituents of conditions. Hence, they are search parameters for judging the acceptability of an SUA. |
| Function | Functions are first class objects in AS$^3$ and even allow polymorphism. Operators such as "equal" are nothing more than a function that takes to parameters and resolves to a value of type Boolean. It is important to note that AS$^3$ optimizes evaluation of functions and allows to execute them either at "script" or at "solver" stage. For this they need to be treated as parameterizable objects. |
| Bind | The AS$^3$ bind construct can link variables to single values and complex expressions outside the scope of the current AS$^3$ fragment. This allows cross-referencing other parts of the document and helps to keep an AS$^3$ model in sync as it avoids repeating of fragments. |

# Fig. 3c

| AS³ Type | Description |
|---|---|
| AS3Type | The base type from which all other types are derived. Each value is at least of type "AS3Type". |
| Undefined | A type with the single value "undefined" to mark the absence of a valid value. |
| Enumeration | An enumeration allows the definition of new value tokes (e.g. to define a type "Performance Level" as the set of the tokens "A", "B", "C", "D") |
| Boolean | Implements the semantics of a classical Boolean type in AS³. |
| Integer | Implements the semantics of a natural numbers type in AS³. The value range can be configured with an AS³ option. |
| Real | Implements the semantics of floating-point type in AS³. The value range can be configured with an AS³ option. |
| String | Implements the semantics of a string type. Of note is the mapping into the domain of constraint solvers as enumeration. Each instantiation of a string value will automatically be added to the value space of an internally managed enumeration. |
| Array | A type to represent arrays of elements of a given other type. |
| Bitvector | Implements an optimization specialization of an array of Booleans. |
| Composite | Base type to define any other composite types (e.g. a complex number type with a real and imaginary part). |
| Asset | Base type definition of a physical assets, which is derived from composite type. Users may use this base class to define their own asset types. A specification may instantiate as many objects of a type as required. |
| User | A specialization type derived from composite to implement a user type according to standard requirements (e.g. having a head, arms, torso, etc.) The user type is instrumental to define various types of hazards. |

# Fig. 3d

Fig. 4

Fig. 5

**Fig. 6**

AS³ Assessment Chip  700

120

AS³ Specification
Document

AS³ Embedded Engine
160

Fig. 7

Fig. 8

900

**s902** — Defining an application section associated with at least one element of an SUA

↓

**s904** — Defining within the application section at least one of a safety section and a security section associated with the at least one element, the at least one of a safety section and security section comprises a plurality of risk related properties

⤷ Specifying a World section — **s914**

↓

**s906** — Mapping the plurality of risk related properties between a natural language to a system semantic, the system semantic associated with a physical or functional property of the system under assessment

↓

**s908** — Specifying at least one condition associated with at least one of a safety breach and a security breach to materialize

⤷ Specifying a Definition section — **s912**

↓

**s910** — Forming an electronic model specification

**Fig. 9**

s1002

Creating an electronic model specification

1000

s1004

Configuring the electronic model specification for evaluation

s1006

Parsing the electronic model specification according to the rules of a modelling language to generate a risk model associated with the SUA, the risk model comprises at least one unmitigated risk

s1008

Interpreting the parsed document to process the definitions specified in the electronic model specification

s1010

Combining or consolidating all referenced specification fragments via an import function

s1012

Collecting referenced parameters form SUA

Continue next page

**Fig. 10**

From previous page

1000

s1014

Executing script evaluation and constraint solvers

s1016

Generating a risk model representing a search space of possible unmitigated risks

**Fig. 10**

**EP 4 027 204 B1**

**Patent documents cited in the description**

- US 2019164095 A1
- US 2019050942 A1
- US 2020111038 A1

**Non-patent literature cited in the description**

- **BJORN AXEL GRAN et al.** Addressing dependability by applying an approach for model-based risk assessment. *Reliability Engineering and System Safety,* 10 July 2007, vol. 92 (11), 1492-1502